# EUROPEAN PATENT APPLICATION

(11) **EP 4 683 044 A2**
(43) Date of publication of application: **21.01.2026**
(21) Application number: 25189816.9
(22) Date of filing: 16.07.2025
(51) Int. Cl.: H01M 10/613, H01M 50/574, H05K 7/00, B60L 3/00

(54) **BUSBARS FOR A POWER DISTRIBUTION UNIT**

(30) Priority: 16.07.2024 US 202463672025 P
(71) Applicant: Eaton Intelligent Power Limited, Dublin D04 Y0C2 (IE)
(72) Inventor: Chauhan, Ankitkumar, Mahesana (IN); Patidar, Deepak, Pratapgarh (IN); Athawale, Vidula, Thane (IN)
(74) Representative: Schwan Schorer & Partner mbB

(57) **Abstract**

In some aspects, the techniques described herein relate to a busbar for electrically connecting components in a power distribution unit (PDU), the busbar including: a first metallic bar configured at one end to be coupled to a terminal of the PDU; and a heat distribution block at the one end of the first metallic bar. In some aspects, the techniques described herein relate to a busbar, wherein the heat distribution block includes a vapor chamber. In some aspects, the techniques described herein relate to a busbar, wherein a shape of the vapor chamber conforms to a shape of the one end. In some aspects, the techniques described herein relate to a busbar, wherein the heat distribution block includes a metal block, wherein the metal block includes a phase change material.

## Description

### BACKGROUND

Power distribution units (PDUs), and more particularly, battery disconnect units (BDU), are vital components in vehicles. These units need to be safeguarded from high temperatures because they are subjected to high surge in currents. The introduction of high current or surges can cause PDUs in a vehicle to overheat. Therefore, mitigating temperature spikes caused by high current surges in PDUs and BDUs is ideal.

### BRIEF SUMMARY

Busbars for dispersing heat and mitigating temperature in power distribution units are described. Advantageously, the described busbars can reduce temperature difference at terminals of a power distribution unit (PDU) to prevent problems caused by high current surges. The described busbars can improve the functioning and lifespan of a PDU by mitigating temperature spikes by acting as a heat spreader and by increasing current carrying capacity.

In some aspects, the techniques described herein relate to a busbar for electrically connecting components in a power distribution unit (PDU), the busbar including: a first metallic bar configured at one end to be coupled to a terminal of the PDU; and a heat distribution block at the one end of the first metallic bar. In some aspects, the techniques described herein relate to a busbar, wherein the heat distribution block includes a vapor chamber. In some aspects, the techniques described herein relate to a busbar, wherein a shape of the vapor chamber conforms to a shape of the one end. In some aspects, the techniques described herein relate to a busbar, wherein the heat distribution block includes a metal block, wherein the metal block includes a phase change material.

In some aspects, the techniques described herein relate to a power distribution unit (PDU), including: a first terminal; and a busbar, wherein the busbar includes: a first metallic bar having one end coupled to the first terminal of the PDU; and a heat distribution block at the one end of the first metallic bar. In some aspects, the techniques described herein relate to a PDU, wherein the PDU includes a battery disconnect unit. In some aspects, the techniques described herein relate to a busbar, wherein the heat distribution block includes a vapor chamber. In some aspects, the techniques described herein relate to a busbar, wherein the heat distribution block includes a metal block, wherein the metal block includes a phase change material.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE DRAWINGS

**Figure 1** illustrates an example embodiment of plurality of busbars coupled to a power distribution unit (PDU).
**Figure 2A** illustrates an example embodiment of a one-sided vapor chamber busbar.
**Figure 2B** illustrates an example embodiment of a two-sided vapor chamber busbar.
**Figure 3A** illustrates an example embodiment of a one-sided vapor chamber busbar.
**Figure 3B** illustrates an example embodiment of a two-sided vapor chamber busbar.
**Figure 3C** illustrates an example embodiment of plurality of busbars coupled to a power distribution unit (PDU).
**Figures 4A-4B** illustrate example embodiments of a phase change material (PCM) busbar. **Figure 4C** illustrates an example PCM slab.
**Figure 5A** illustrates a graph illustrating effects of vapor chamber busbar with one-sided architecture.
**Figure 5B** illustrates a temperature map of terminals of a PDU coupled by a contact bridge using conventional busbars. **Figure 5C** illustrates a temperature map of terminals of a PDU coupled by a contact bridge using a vapor chamber busbar with one-sided architecture.

### DETAILED DESCRIPTION

Busbars for dispersing heat and mitigating temperature in power distribution units (PDUs) are described. Advantageously, the described busbars can reduce temperature difference at terminals of a PDU to prevent problems caused by high current surges. The described busbars can improve the functioning and lifespan of a PDU by mitigating temperature spikes by acting as a heat spreader and by increasing current carrying capacity.

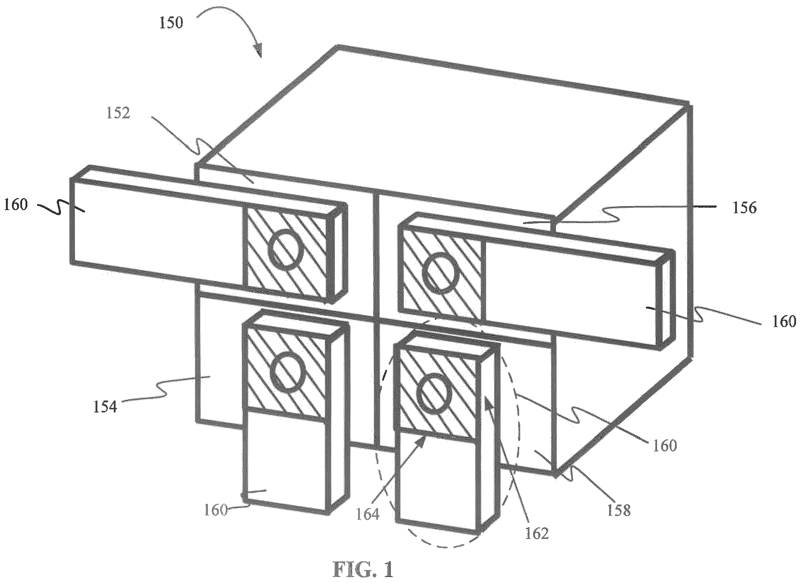

**Figure 1** illustrates an example embodiment of plurality of busbars coupled to a power distribution unit (PDU). Referring to **Figure 1****,** PDU **150** includes a first terminal **152,** a second terminal **154,** a third terminal **156,** and a fourth terminal **158**. A plurality of busbars **160** can be coupled to the terminals of the PDU **150.**

In some cases, the PDU **150** is a PDU in a vehicle. Example PDUs **150** can include, but are not limited to, a battery, a battery disconnect unit (BDU), a generator, an inverter, a converter, and a capacitor. In some cases, the PDU **150** provides for protection of the electrical system, including fusing and/or connection or disconnection of an electrical system (e.g., a vehicle) or individual aspects of the electrical systems. The first terminal **152** can be coupled to the third terminal **156** by a contact bridge (not shown) within the body of the PDU **150.**

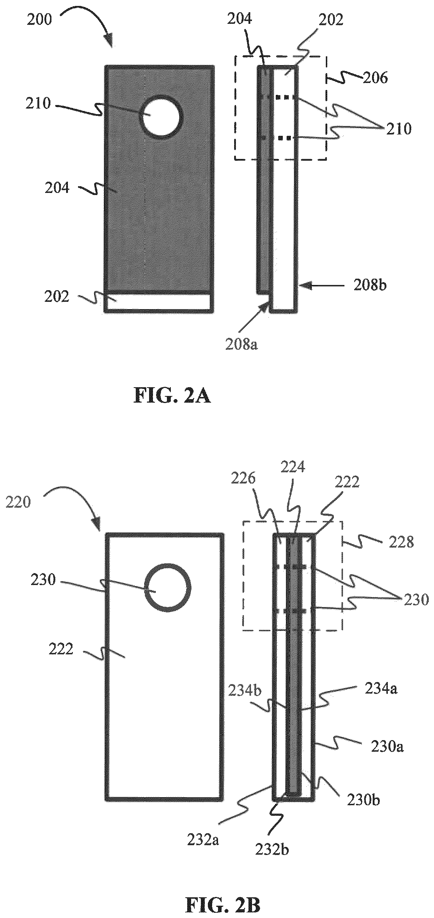

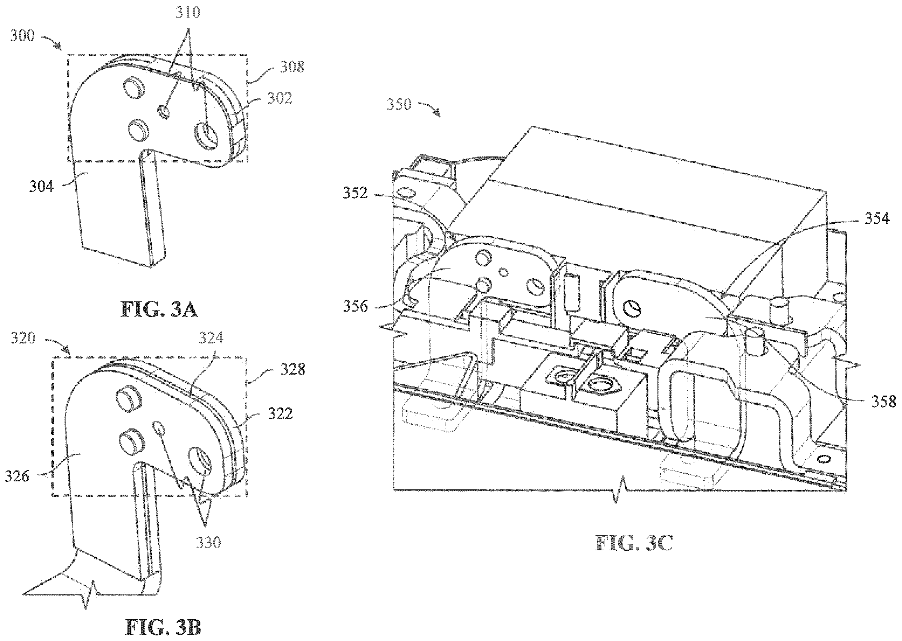

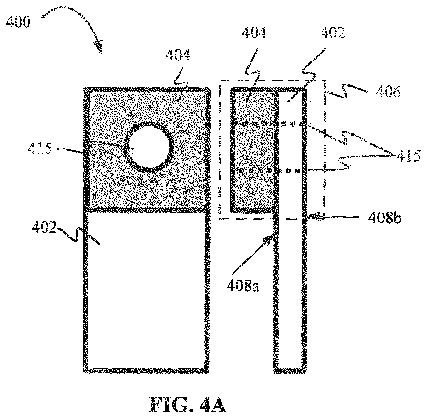

Each of the plurality of busbars **160** can include a first metallic bar **162** configured at one end to be coupled to a terminal of the PDU (e.g., fourth terminal **158**) and a heat distribution block **164** at the one end of the first metallic bar. The heat distribution block can conform to a shape of the one end. In some cases, the heat distribution block **164** can be embodied as a vapor chamber, as described with respect to **Figures 2A-2B** and **Figures 3A-3B**. In some cases, the heat distribution block **164** can be embodied as a metal block, wherein the metal block includes a phase change material, for example, as described with respect to **Figures 4A-4C****.**

The plurality of busbars **160** can be coupled to a terminal of the PDU **150** (e.g., first terminal **152,** second terminal **154,** third terminal **156,** and fourth terminal **158**) to distribute high current power at the PDU **150.** Each of the plurality of busbars **160** can be an electrical connection point that gathers electric power from an incoming power line through which electricity is passed in a PDU and then disperses the electrical power to an outgoing power line. The plurality of busbars **160** transport and distribute electricity to enhance the efficiency of the systems.

**Figure 2A** illustrates an example embodiment of a one-sided vapor chamber busbar. Referring to **Figure 2A**, a one-sided vapor chamber busbar **200** can include a metallic bar **202** and a vapor chamber **204.** The vapor chamber **204** is a thin vacuum-sealed metal enclosure/envelope that includes a liquid and an internal wick structure (e.g., microstructures).

The metallic bar **202** can be configured at one end to be coupled to a terminal of a PDU (e.g., terminal contact portion **206**). The vapor chamber **204** can conform to a shape of the one end. The vapor chamber **204** can be at the terminal contact portion **206** of the metallic bar **202.** In some cases, the vapor chamber **204** can be close to the terminal contact portion **206** of the busbar **200.** In some cases, the vapor chamber **204** can extend a distance down a length of the one-sided vapor chamber busbar **200.** The one-sided vapor chamber busbar **200** can include a hole **210** extending through the one-sided vapor chamber busbar **200** (e.g., including a hole formed in the vapor chamber **204** and a corresponding hole formed in the metallic bar **202**).

Advantageously, the vapor chamber **204** can decrease the temperature differential between a terminal contact portion **206** of the one-sided vapor chamber busbar **200** and an end portion on the opposite side of the one-sided vapor chamber busbar **200.** The vapor chamber **204** can spread heat in two dimensions. The liquid within the vapor chamber **204** evaporates and condenses to efficiently transfer heat. In some cases, the vapor chamber **204** has a thickness selected from a range of 0.5mm-5mm.

The metallic bar **202** can be formed of any suitable metal, including, but not limited to, copper, brass, and aluminum. In some cases, the metallic bar **202** can have a thickness selected from a range of 1mm to 10mm. In some cases, the metallic bar **202** has a thickness of 3mm.

The vapor chamber **204** can be coupled to the metallic bar **202.** The metallic bar **202** can include a first side **208a** coupled to the vapor chamber **204** and a second side **208b** configured to be coupled to a terminal of a PDU (e.g., the first terminal **152,** the second terminal **154,** the third terminal **156,** or the fourth terminal **158** of PDU **150** as described with respect to **Figure 1**). The one-sided vapor chamber busbar **200** can include a terminal contact portion **206** at the one end of the one-sided vapor chamber busbar **200** configured to be coupled to a terminal of a PDU.

The one-sided vapor chamber busbar **200** can be a variety of shapes/sizes suitable for coupling to a terminal of PDU. Example shapes for the one-sided vapor chamber busbar **200** include a flat strip, a solid bar, and a rod. In some cases, the one-sided vapor chamber busbar **200** is curved, such that the terminal contact portion **206** is offset from an extending portion of the one-sided vapor chamber busbar **200.** The metallic bar **202** can be formed of any suitable metal, including, but not limited to, copper, brass, and aluminum. In some cases, the shape of the vapor chamber **204** corresponds to the shape of the metallic bar **202.**

**Figure 2B** illustrates an example embodiment of a two-sided vapor chamber busbar. Referring to **Figure 2B****,** a two-sided vapor chamber busbar **220.** The two-sided vapor chamber busbar **220** can include a first metallic bar **222** configured at one end (e.g., terminal contact portion **228**) to be coupled to a terminal of a PDU (e.g., the first terminal **152,** the second terminal **154,** the third terminal **156,** or the fourth terminal **158** of PDU **150** as described with respect to **Figure 1**), a vapor chamber **224,** and a second metallic bar **226** coupled to the first metallic bar **222** with the vapor chamber **224** there between. In some cases, the second metallic bar **226** can contact the first metallic bar **222** toward an opposite end to the one end having the vapor chamber (e.g., the terminal contact portion **228**). The two-sided vapor chamber busbar **220** can include a hole **230** extending through the two-sided vapor chamber busbar **220** (e.g., including a hole formed in the vapor chamber **224,** a corresponding hole formed in the first metallic bar **222,** and a corresponding hole formed in the second metallic bar **226**).

The vapor chamber **224** of the two-sided vapor chamber busbar **220** can be coupled to both the first metallic bar **222** and the second metallic bar **226.** The first metallic bar **222** can include a first side **230a** configured to be coupled to a terminal of a PDU and a second side **230b** coupled to a first side **234a** the vapor chamber **224.** The second metallic bar **226** can include a first side **232a** and a second side **232b** coupled to a second side **234b** of the vapor chamber **224.** The two-sided vapor chamber busbar **220** can include a terminal contact portion **228** at an end of the two-sided vapor chamber busbar **220** configured to be coupled to a terminal of a PDU.

In some cases, the first metallic bar **222** is coupled to the second metallic bar **226.** In some cases, a bottom end of the first metallic bar **222** is coupled to a bottom end of the second metallic bar **226.** In some cases, the first metallic bar **222** is coupled to the second metallic bar at a bottom end of the two-sided vapor chamber busbar **220** (e.g., an end opposite the terminal contact portion **228** of the two-sided vapor chamber busbar **220**).

The two-sided vapor chamber busbar **220** can be a variety of shapes/sizes suitable for coupling to a terminal of PDU. Example shapes for the two-sided vapor chamber busbar **220** include a flat strip, a solid bar, and a rod. In some cases, the two-sided vapor chamber busbar **220** is curved, such that the terminal contact portion **228** is offset from an extending portion of the two-sided vapor chamber busbar **220.** The first metallic bar **222** and the second metallic bar **226** can be forrned of any suitable metal, including, but not limited to, copper, brass, and aluminum. In some cases, the shape of the vapor chamber **224** corresponds to the shape of the first metallic bar **222** and the second metallic bar **226.**

**Figure 3A** illustrates an example embodiment of a one-sided vapor chamber busbar. Referring to **Figure 3A****,** a one-sided vapor chamber busbar **300** can include similar components as the one-sided vapor chamber busbar **200** as described with respect to **Figure 2A****.** The one-sided vapor chamber busbar **300** includes a metallic bar **302** and a vapor chamber **304.** The one-sided vapor chamber busbar **300** can include a terminal contact portion **308** that is offset from an extending portion of the one-sided vapor chamber busbar **300.** The one-sided vapor chamber busbar **300** can include a plurality of holes **310** extending through the one-sided vapor chamber busbar **300** (e.g., including a plurality of holes formed in the vapor chamber **304** and a corresponding plurality of holes formed in the metallic bar **302**).

**Figure 3B** illustrates an example embodiment of a two-sided vapor chamber busbar. Referring to **Figure 3B****,** the two-sided vapor chamber busbar **320** can include similar components as the two-sided vapor chamber busbar **320** as described with respect to **Figure 3B****.** The two-sided vapor chamber busbar **320** includes a first metallic bar **322,** a vapor chamber **324,** and a second metallic bar **326.** The two-sided vapor chamber busbar **320** can include a terminal contact portion **328** that is offset from an extending portion of the two-sided vapor chamber busbar **320.**

The two-sided vapor chamber busbar **320** can include a plurality of holes **330** (e.g., including a plurality of holes formed in the vapor chamber **324,** a corresponding plurality of holes formed in the first metallic bar **322,** and a corresponding plurality of holes formed in the second metallic bar **326**).

**Figure 3C** illustrates an example embodiment of plurality of busbars coupled to a power distribution unit (PDU). Referring to **Figure 3C****,** the PDU **350** includes a first terminal **352,** a second terminal **354,** a first busbar **356,** and a second busbar **358.** Referring to **Figures 3A-3C****,** the first busbar **356** and the second busbar **358** can be embodied as a one-sided vapor chamber busbar **300** or a two-sided vapor chamber busbar **320.**

**Figures 4A-4B** illustrate example embodiments of a phase change material (PCM) busbar.

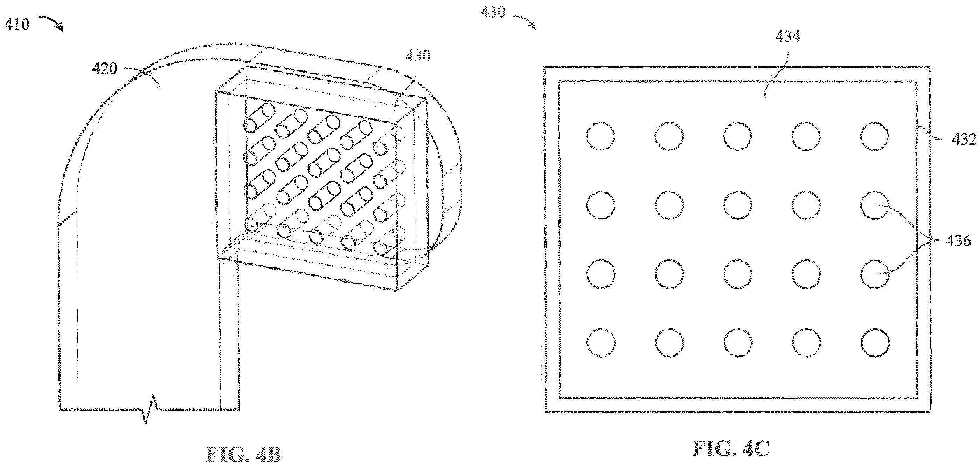

**Figure 4C** illustrates an example PCM slab.

Referring to **Figure 4A****,** a PCM busbar **400** can include a first metallic bar **402** and a heat distribution block embodied as a phase change material (PCM) component **404.** In some cases, the PCM component **404** is encapsulated by a metal block (i.e., metal slab). The first metallic bar **402** can include a first side **408a** coupled to the PCM component **404** and a second side **408b** configured to be coupled to a terminal of a PDU (e.g., first terminal **152,** second terminal **154,** third terminal **156,** and fourth terminal **158** of PDU **150** as described with respect to **Figure 1****,** the first terminal **352** or the second terminal **354** as described with respect to **Figure 3C**). The PCM busbar **400** can include a terminal contact portion **406** at the end of the PCM busbar **400** configured to be coupled to a terminal of a PDU. The PCM component **404** can be close to the terminal contact portion **406** of the PCM busbar **400.** The PCM busbar **400** can include a hole **415** (e.g., including a hole formed in the PCM component **404** and a corresponding hole formed in the first metallic bar **402**).

Referring to **Figures 4B-4C****,** the PCM busbar **410** includes a metallic bar **420** and a PCM component **430.** The PCM component **430** includes a PCM **434.** In some cases, the PCM **434** is encapsulated by a metal slab **432** (i.e., metal block). In some cases, the metal slab **432** is a metal block containing the PCM **434.** The PCM component **430** is coupled to a side of the metallic bar **420.**

Example materials for forming the metal slab **432** can include, but are not limited to, aluminum, copper, silver, and a thermally conductive polymer.

In some cases, the PCM **434** of the PCM component **430** includes a plurality of holes **436** extending therethrough.

Example materials for the PCM **434** can include, but are not limited to, salt hydrates, fatty acids, esters, and various paraffins (e.g., octadecane). In some cases, a material for the PCM **434** is selected to have a melting temperature proximate to a "critical to quality" (CTQ) temperature of PDU terminal and high latent heat capacity.

The shape of the PCM component **430** can vary based on space constraints and the specifications of the particular PDU. In some cases, the shape of the PCM component **430** is selected to fit available space and to ensure effective heat absorption and dissipation at terminals.

Advantageously, when a PCM busbar **410** is coupled to a terminal of a PDU and a current spike occurs resulting in temperatures that reach a melting point of the PCM **434,** a phase change process occurs which temporarily absorbs excess heat to reduce the temperature at the terminal.

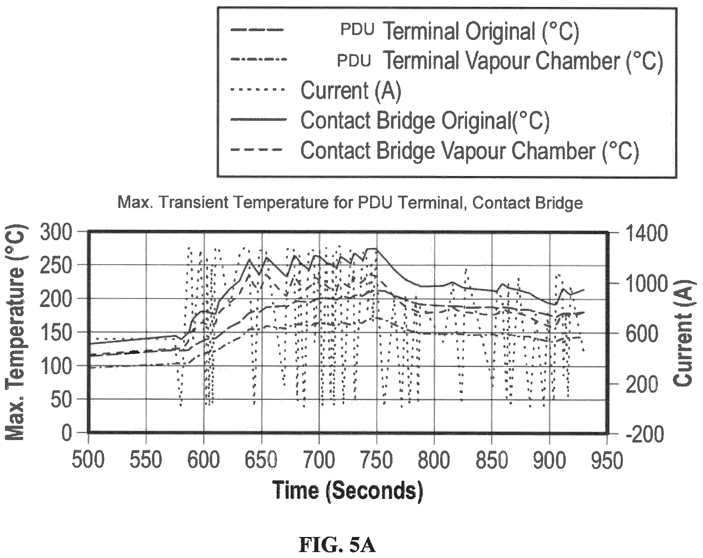

**Figure 5A** illustrates a graph illustrating effects of vapor chamber busbar with one-sided architecture. Referring to **Figure 5A**, the solid lines illustrate Reactor (e.g., PDU **150** as described with respect to **Figure 1** or PDU **350** as described with respect to **Figure 3C**) terminal temperature when a conventional busbar is used and the dotted lines illustrate terminal temperature when a one-sided vapor chamber busbar is used.

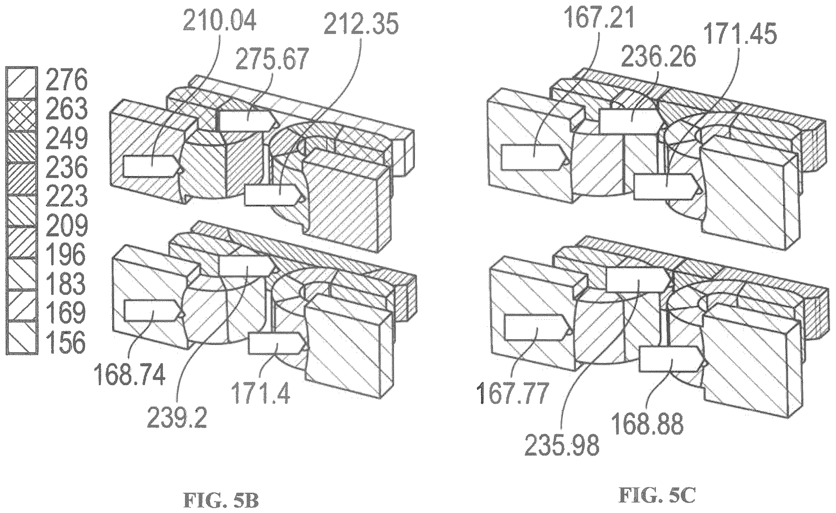

**Figure 5B** illustrates a temperature map of terminals of a PDU coupled by a contact bridge using a conventional busbar. **Figure 5C** illustrates a temperature map of terminals of a PDU coupled by a contact bridge using a one-sided vapor chamber busbar.

Referring to **Figures 5A-5C****,** as can be seen, the maximum temperature for the Reactor (e.g., PDU **150** as described with respect to **Figure 1** or PDU **350** as described with respect to **Figure 3C**) can be reduced by approximately 40°C by using a one-sided vapor chamber (e.g., one-sided vapor chamber busbar **200** as described with respect to **Figure 2A** or one-sided vapor chamber busbar **300** as described with respect to **Figure 3A**). Similar temperature reduction effects can be achieved using a two-sided vapor chamber (e.g., two-sided vapor chamber busbar **220** as described with respect to **Figure 2B** or two-sided vapor chamber busbar **320** as described with respect to **Figure 3B**) or a PCM busbar (e.g., PCM busbar **400** as described with respect to **Figure 4A** and PCM busbar **410** as described with respect to **Figure 4B**).

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

## Claims

1. A busbar (160, 200, 220, 300, 320, 400, 410) for electrically connecting components in a power distribution unit (PDU) (150), the busbar comprising:
a first metallic bar (162, 202, 222, 302, 322, 402, 420) configured at one end to be coupled to a terminal (152, 154, 1 56, 158) of the PDU; and
a heat distribution block (164) at the one end of the first metallic bar.

2. The busbar of claim 1, wherein the heat distribution block comprises a vapor chamber (204, 224, 304, 324).

3. The busbar of claim 2, wherein a shape of the vapor chamber conforms to a shape of the one end.

4. The busbar of claim 3, wherein the one end is offset from an extending portion of the busbar.

5. The busbar of claim 2, further comprising a second metallic bar (226, 326) coupled to the first metallic bar with the vapor chamber there between.

6. The busbar of claim 5, wherein the second metallic bar contacts the first metallic bar toward an opposite end to the one end having the vapor chamber.

7. The busbar of claim 1, wherein the heat distribution block comprises a metal block (404, 432), wherein the metal block comprises a phase change material (404, 434).

8. The busbar of claim 7, wherein the phase change material is encapsulated within the metal block.

9. The busbar of claim 7, wherein the phase change material comprises a plurality of holes (436).

10. A power distribution unit (PDU) (150), comprising:
a first terminal (152); and
a busbar (160, 200, 220, 300, 320, 400, 410), wherein the busbar comprises:
a first metallic bar (162, 202, 222, 302, 322, 402, 420) having one end coupled to the first terminal of the PDU; and
a heat distribution block (164) at the one end of the first metallic bar.

11. The PDU of claim 10, wherein the PDU comprises a battery disconnect unit.

12. The PDU of claim 10, wherein the heat distribution block comprises a vapor chamber (204, 224, 304, 324).

13. The PDU of claim 12, further comprising a second metallic bar (226, 326) coupled to the first metallic bar with the vapor chamber there between.

14. The PDU of claim 10, wherein the heat distribution block comprises a metal block (404, 432), wherein the metal block comprises a phase change material (404, 434).

15. The PDU of claim 14, wherein the phase change material is encapsulated within the metal block.
